Europäisches Patentamt

European Patent Office

Office européen des brevets

(11) Publication number: **0 415 663 A1**

# EUROPEAN PATENT APPLICATION

(21) Application number: 90309302.9

(22) Date of filing: 24.08.90

(51) Int. Cl.⁵: **H05K 13/00**

(30) Priority: 28.08.89 JP 221228/89

(43) Date of publication of application:
06.03.91 Bulletin 91/10

(84) Designated Contracting States:
**DE GB NL**

(71) Applicant: **SEIKO EPSON CORPORATION**
**4-1, Nishishinjuku 2-chome**
**Shinjuku-ku Tokyo(JP)**

(72) Inventor: **Muramatsu, Eiji, c/o SEIKO EPSON**
**CORPORATION**
**3-5 Owa, 3-chome**
**Suwa-shi, Nagano-ken(JP)**
Inventor: **Kamimura, Masaru, c/o SEIKO**
**EPSON CORPORATION**
**3-5 Owa, 3-chome**
**Suwa-shi, Nagano-ken(JP)**

(74) Representative: **Miller, Joseph et al**
**J. MILLER & CO. Lincoln House 296-302 High**
**Holborn**
**London WC1V 7JH(GB)**

(54) Tape assembly.

(57) A tape assembly comprising a flexible printed circuit (FPC) tape (1) which carries a plurality of semiconductor apparatuses (2) characterised in that each semiconductor apparatus (2) is fastened to the said FPC tape (1) at limited regions (2b,2c) only.

FIG. 1.

EP 0 415 663 A1

## "TAPE ASSEMBLY"

This invention concerns a tape assembly, a method of effecting outer lead bonding employing said tape assembly, and an apparatus for making the said tape assembly.

In a prior method known to the Applicants, when effecting outer lead bonding (hereinafter called OLB) of semiconductor apparatuses mounted on a flexible printed circuit (hereafter called FPC) tape, the semiconductor apparatuses were separated as single solid-state units from the FPC tape, and OLB was carried out with the elements in a non-taped state.

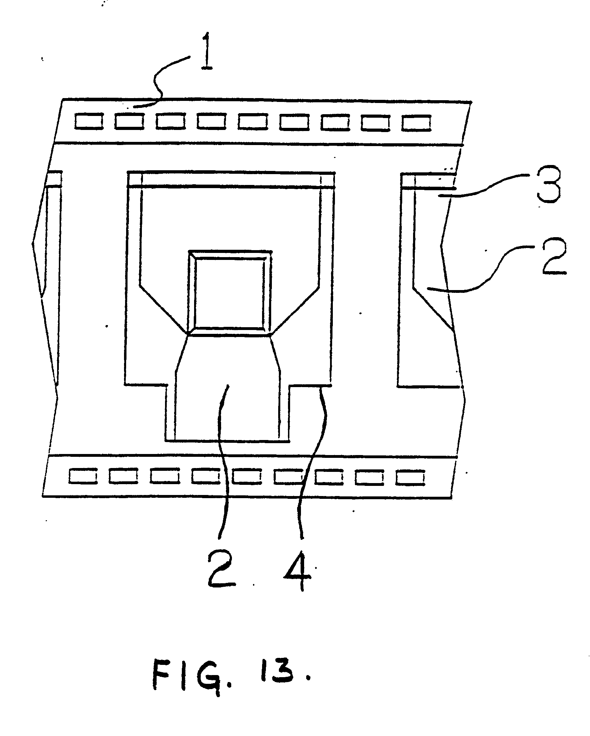

That is, as shown in Figure 13, each semiconductor apparatus 2 on a FPC tape 1 was cut at external cut lines 4, so as to be completely separated from the FPC tape 1, and OLB was carried out on the semiconductor apparatus 2 in the non-taped state.

Consequently, in the prior OLB process, individual semiconductor apparatuses were separated from the FPC tape so that it was difficult to automate the OLB process, and even if automated, there were problems in raising production efficiency.

The object of the present invention is to provide a tape assembly which can easily be used in an automated process so as to provide high production efficiency.

According to the present invention, there is provided a tape assembly comprising a flexible printed circuit (FPC) tape which carries a plurality of semiconductor apparatuses characterised in that each semiconductor apparatus is fastened to the said FPC tape.at limited regions only.

Each semiconductor apparatus may be fastened to the FPC tape only by means of at least one adhesive flexible tape member which is secured to the said FPC tape.

Alternatively, each semiconductor apparatus may be fastened to the FPC tape only by means of thin connector members.

Preferably, the FPC tape is provided with holes on at least one side of each semiconductor apparatus, each semiconductor apparatus having been completely cut from the FPC tape along at least one cut line incorporating a respective hole or holes, each semiconductor apparatus being fastened to the FPC tape only by fastening means which extend across the respective hole or holes.

Each semiconductor apparatus may have at least one pair of holes disposed on opposite sides thereof.

Each semiconductor apparatus is preferably constituted by a single solid state unit.

The invention also comprises a method of effecting outer lead bonding (OLB) of a plurality of semiconductor apparatuses mounted on a flexible printed circuit (FPC) tape characterised in that each semiconductor apparatus is fastened to the said FPC tape at limited regions only at or immediately prior to the time when OLB is effected.

Each semiconductor apparatus is preferably fastened to the said FPC tape by fastening means which are severed immediately prior to the time when OLB is effected.

Thus the fastening means may be severed by melting it.

Preferably, prior to the said OLB, each semiconductor apparatus has inner lead bonding (ILB) carried out thereon at a time when the semiconductor apparatus is securely fastened to the FPC tape and prior to the time when it is fastened thereto only at the said limited regions.

The invention also comprises an apparatus for making the said tape assembly, the apparatus being characterised by first securing means for securing a plurality of semiconductor apparatus to a flexible printed circuit (FPC) tape; second securing means for securing each semiconductor apparatus to the FPC tape by means of adhesive flexible tape; and cutting means for cutting each semiconductor apparatus away from the FPC tape while leaving it fastened thereto at limited regions only by the adhesive flexible tape.

Preferably, the apparatus has further cutting means for completely separating each semiconductor apparatus from the FPC tape by severing the adhesive flexible tape which fastened it thereto.

There are preferably positioning means for positioning a semiconductor apparatus, which has been completely separated from the FPC tape, with respect to a terminal part of a substrate so that they mutually face one another, and electrical connection means for electrically connecting together terminal parts of the semiconductor apparatus and of the substrate.

The invention is illustrated, merely by way of example, in the accompanying drawings, in which:-

Figures 1 to Figure 4, (a) to (h), are plan views of parts of a tape assembly according to the present invention;

Figure 5 is a drawing illustrating the use of the tape assembly of the present invention;

Figure 6(a) through are are sectional views along C-C in Figure 5;

Figure 7 is a view illustrating the use of the tape assembly of the present invention;

Figure 8(a) and (b) are sectional views along D-D in Figure 7;

Figures 9 to 11 illustrate a method of using the tape assembly of the present invention;

Figure 12 is a drawing of an apparatus for making the tape assembly of the present invention; and

Figure 13 is a drawing showing a tape assembly known to the Applicants.

## EXAMPLE 1

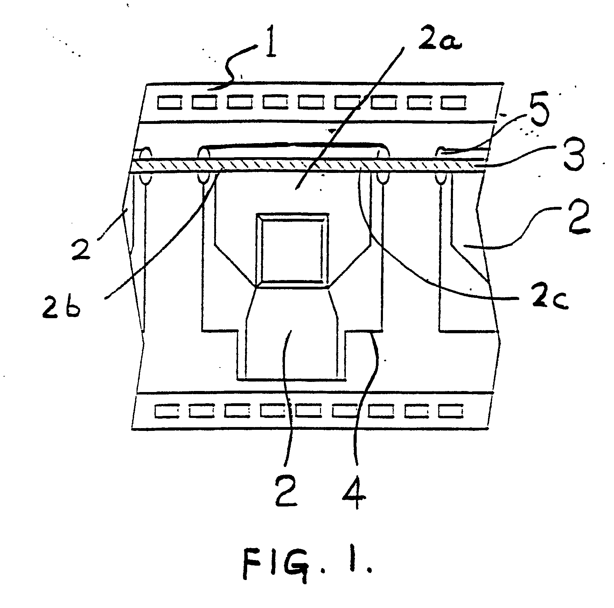

Figure 1 is a plan view of a tape assembly according to the present invention comprising a plurality of semiconductor apparatuses 2 which are carried by an FPC tape 1, each semiconductor apparatus 2 being constituted by a single solid state unit. An adhesive flexible tape (FT) 3 is attached continuously to the FPC tape 1. The adhesive FT 3 is moreover attached to the OLB terminal 2a of each semiconductor apparatus 2. Consequently, even when each semiconductor apparatus 2 is completely cut from the FPC tape 1 at external cut lines 4, it is held fastened in the same position as before it was cut. Thus it is held in position on the FPC tape 1 at the external cut lines 4 by means of the adhesive FT 3. The adhesive FT 3 is able to maintain the semiconductor 2 attached to the FPC tape 1 in the manner described because it extends across slit holes 5 in the FPC tape 1, each semiconductor apparatus 2 being completely cut from the FPC tape 1 along cut lines 4 which incorporate the respective holes 5. That is to say, the FPC tape 1 is pre-formed with a plurality of slit holes 5, each semiconductor apparatus 2 having a pair of slit holes which are respectively disposed on opposite sides thereof. The adhesive FT 3 crosses the slit holes 5. The external cut lines 4 of each semiconductor apparatus 2 extend between the respective slit holes 5 of the semiconductor apparatus 2.

The material of the FPC tape 1 comprises synthetic resin such as polyimide, polyester, glass epoxy and paper phenol. The width of the FPC tape 1 is from about 20 mm to about 100 mm; the thickness of the FPC tape 1 is from about 10 microns to about 150 microns; and the length of the FPC tape 1 is from several metres to a hundred or several tens of metres.

The adhesive FT 3 may comprise an anisotropic conducting film (hereafter called ACF) capable of electrically connecting the OLB terminals 2a of the semiconductor apparatuses 2 with a terminal (not shown) for OLB of an OLB element (not shown) but anything that is flexible and has adhesive on it is suitable. Examples of suitable adhesive FT 3 are tapes made of resin such as polyimide and polyester, and cloth or glass fiber cloth.

As will be seen from Figure 1, each of the semiconductor apparatuses 2 is fastened to the FPC tape 1 only at the parts 2b, 2c and thus only at limited regions thereof.

## EXAMPLE 2

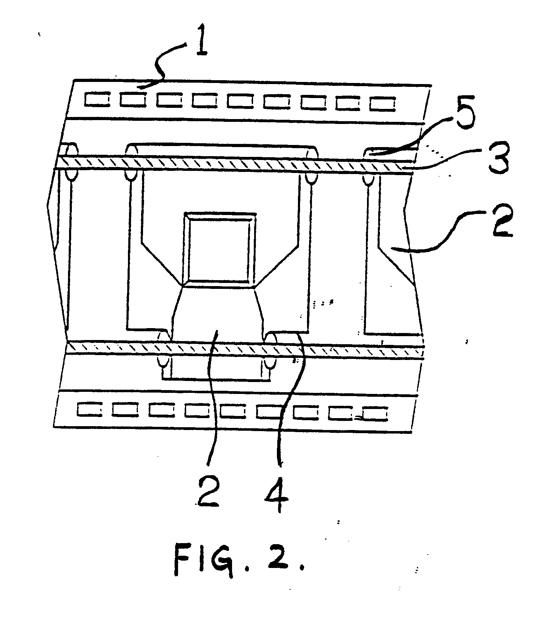

Figure 2 is a plan view showing another embodiment of a tape assembly according to the present invention. The embodiment of Example 2, as compared to that of Example 1 shown in Figure 1, is characterized in that adhesive FT 3 is employed at two spaced apart places. The remaining features of Example 2 are identical to those of Example 1.

## EXAMPLE 3

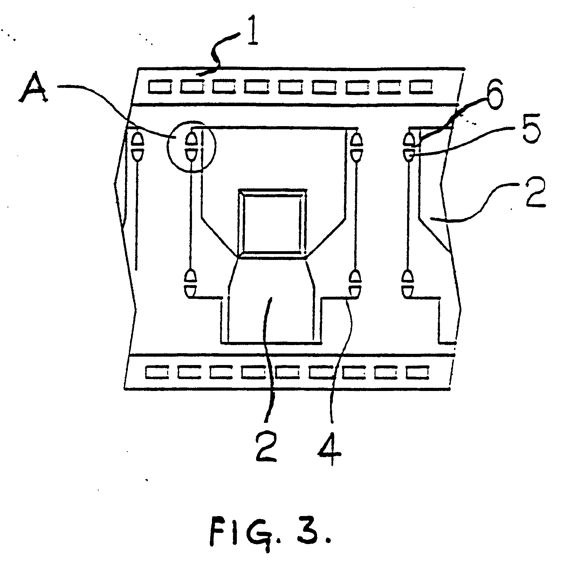

Figure 3 is a plan view showing another embodiment of a tape assembly according to the present invention. The embodiment of Figure 3, as compared to Example 1 and to Example 2, is characterized in that each slit hole 5 has a minute or other thin connector 6 across it in order to maintain each semiconductor apparatus 2 attached to the FPC tape 1, even after the semiconductor apparatus 2 has been cut from the FPC tape 1 at the external cut lines 4, and without using adhesive FT 3.

By not cutting the minute connectors 6 which extend across the slit holes 5 when cutting the semiconductor apparatuses 2 from the FPC tape 1 at the external cut lines 4, the same effect is obtained as With the adhesive FT 3 of Example 1 and Example 2. Moreover, the minute connectors 6 can be provided at any position on the outer periphery of the semiconductor apparatuses 2.

## EXAMPLE 4

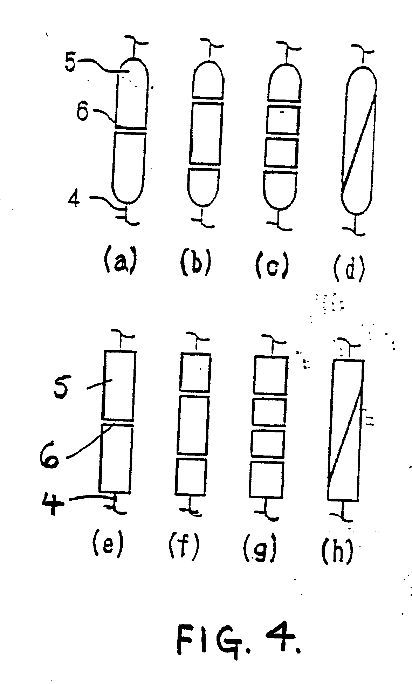

Figures 4(a) through (h) are plan views showing various embodiments of parts of tape assemblies according to the present invention, the various plan views relating to the area shown at A in Figure 3 and showing various shapes which may be adopted for the slit holes 5 and various dispositions which may be employed for the minute connectors 6.

Figure 4,(a) to (d) show cases where the slit hole 5 is oval, and (e) to (h) show cases where the slit hole 5 is rectangular. Also, Figure 4, (a) and (e), show cases where the minute connectors 6 are provided singly in the central part of the slit hole 5; (b) and (f) show cases where the minute connectors 6 are provided in duplicate; Figure 4, (c) and (g), show cases where the minute connectors 6 are provided in triplicate; and Figure 4, (d) and (h) show cases where the minute connectors 6 slant sideways in the slit holes 5.

In the case of each of Examples 1, 2, 3, 4, the sizes of the slit holes 5 were from 0.3 mm to about 5.0 mm in width, and from 2.0 mm to about 10 mm in length. Moreover, the widths of the minute connectors 6 were from 0.1 mm to about 1.0 mm.

EXAMPLE 5

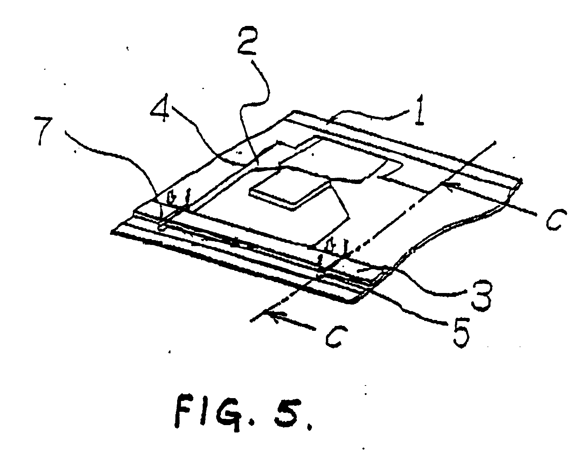

Figure 5 is a drawing illustrating one embodiment of a method according to the present invention for using the said tape assembly. In Figure 5, one part of the semiconductor apparatus 2 is attached to the FPC tape 1 with adhesive FT 3, but another part thereof has already been cut out from the FPC tape 1 at the external cut line 4.

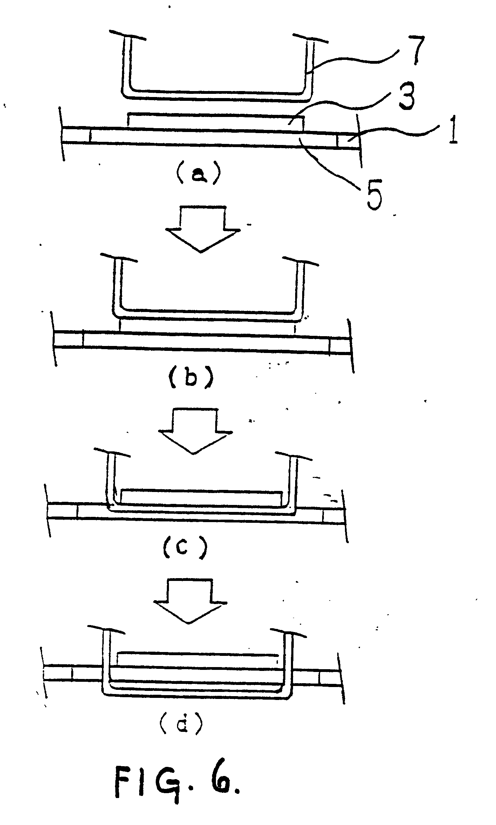

Immediately before effecting the outer lead bonding of the semiconductor apparatus 2 to the terminal used for OLB on the OLB element, the semiconductor apparatus 2 can be separated from the FPC tape 1 by cutting the adhesive FT 3. The steps for carrying this out are shown in Figure 6(a) to (d), these views being along section C-C in Figure 5.

In Figure 6(a), the adhesive FT 3 is attached to the FPC tape 1. A cutter 7 is shown as standing by directly over the semiconductor apparatus 2 and a slit hole 5 of the FPC tape 1, in Figure 6(b), the cutter 7 is shown as having dropped down to a position where it may or may not contact the adhesive FT 3. In this state, heating of the cutter 7 is effected by passing electric current through the cutter 7. In Figure 6(c) the heated cutter 7 is shown as having dropped further so that it cuts the adhesive FT 3 by melting it. In Figure 6(d), the cutter 7 is shown as having dropped still further so that it cuts the adhesive FT 3 completely. In this manner, the semiconductor apparatus 2 is cut off from the FPC tape 1 by advancing from the state shown in Figure 6(a) to the state shown in (d).

By using a method as described above, it is possible to transport the semiconductor apparatuses 2 in a taped state and in roll form until just before OLB.

Further, in the present example, only about 0.1 A of electric current was used when the cutter 7 was a nichrome wire cutter, 1.0mm in diameter.

EXAMPLE 6

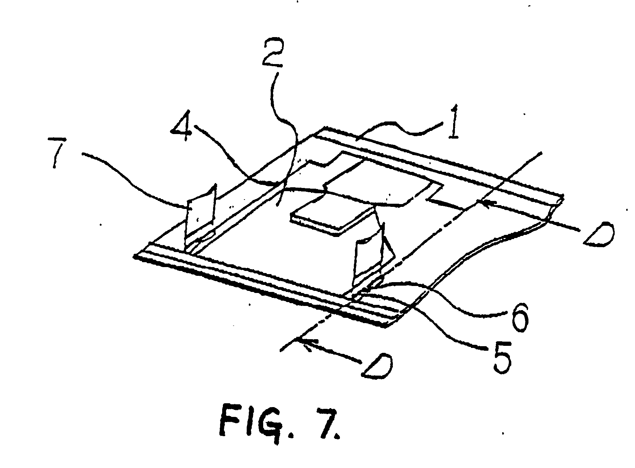

Figure 7 is a drawing illustrating another embodiment of a method according to the present invention for assembling a tape assembly.

In Figure 7, the semiconductor apparatus 2 shown is cut off from the FPC tape 1 at external cut lines 4, but remains connected to the FPC tape 6 by minute connectors 6 which cross the slit holes 5.

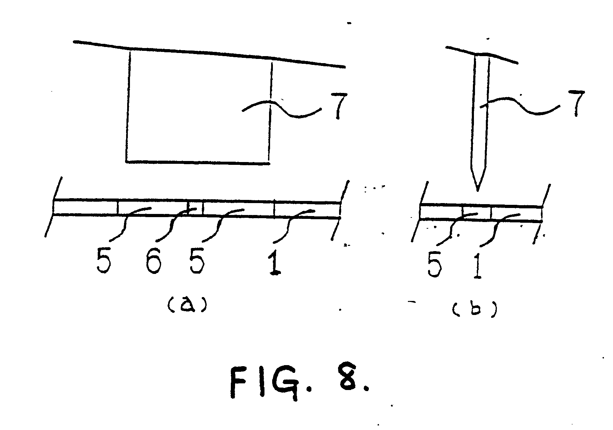

The semiconductor apparatus 2 can be separated from the FPC tape 1 by cutting the minute connectors 6 just before the semiconductor apparatus 2 is provided with outer lead bonding at the OLB terminal of the OLB element. This is shown in detail in Figure 8(a) and (b) where Figure 8(a) is a sectional view along D-D of Figure 7. At Figure 8, (a) and (b), the cutter 7 is shown as standing by directly over a slit hole 5 of the semiconductor apparatus 2 and the FPC tape 1. In this example, the cutter 7 falls in the same manner as in Example 5, the minute connectors 6 are cut, and the semiconductor apparatus 2 is cut off from the FPC tape 1. By this method, the semiconductor apparatuses 2 can be transported in the taped state and in roll form until just before OLB.

Further, a sharp cutter made of stainless steel was used as the cutter 7 in the present example.

EXAMPLE 7

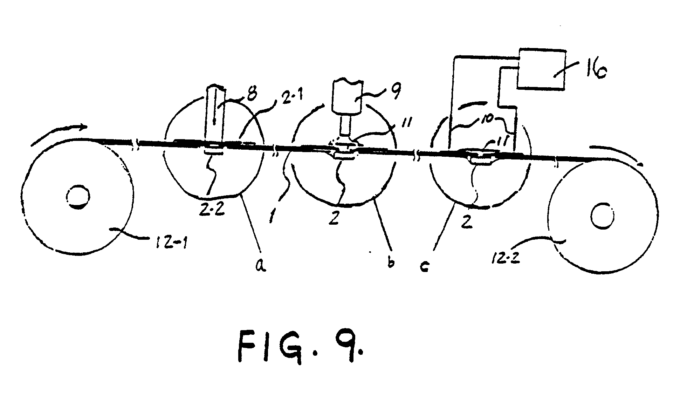

Figure 9 illustrates a method of inner lead bonding (hereafter called ILB) which may be carried out prior to the OLB described above.

In Figure 9, a wiring circuit part 2-1 of the semiconductor apparatus 2 is placed on the FPC tape 1, and the FPC tape 1 is wound on a reel 12-1. The FPC tape 1 is drawn from the reel 12-1 and, in the region (a), a semiconductor element 2-2 of the semiconductor apparatus 2 is attached under hot compression by a bonding tool 8 to the wiring circuit part 2-1 of the semiconductor apparatus 2 on the FPC tape 1, and is connected electrically and mechanically by a gang bonding method. Then, in the region (b), the semiconductor apparatus 2 on the FPC tape 1 is painted with adhesive 11 ejected from a nozzle 9. Further, the painting of the adhesive 11 may be effected by a method such as printing. Next after hardening the adhesive 11 by passing it through a thermostatic furnace (not shown), the semiconductor apparatus 2 on the FPC tape 1 is given, in the region (c), an electrical inspection by placing probes 10 of an inspection device 16 in contact with terminals of the semiconductor apparatus 2. After this, the FPC tape 1 is wound up again onto a reel 12-2. In this way, it is possible to process the semiconductor apparatuses 2 continuously in one pass and in the taped state during an ILB process which precedes the OLB process described above.

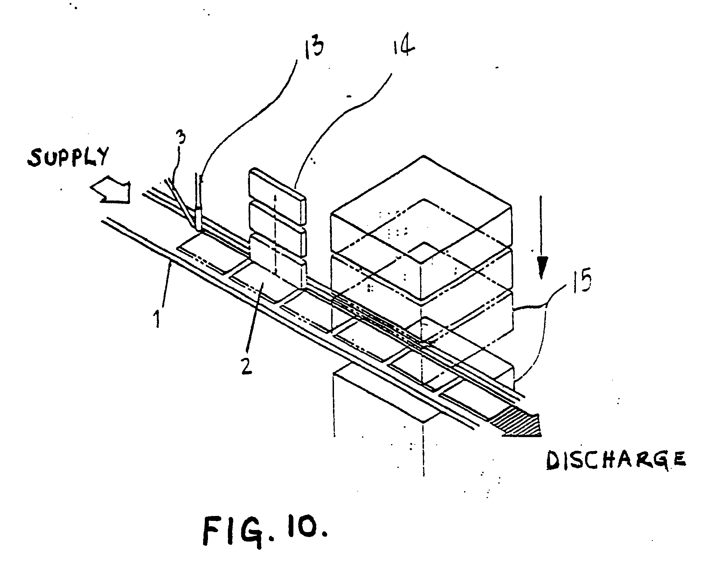

Figure 10 is a schematic drawing that shows the adhesive FT 3 attached to the FPC tape 1 up to the external cut of the semiconductor apparatus 2. The adhesive FT 3 on the FPC tape 1 is temporarily held by an FT temporary press tool 13, after which it is pressed and adhered to the FPC tape 1 by an hot press adhesion device 14. Then, each semiconductor apparatus 2 on the FPC tape 1 is cut by an external cut device 15 along the external cut lines 4, leaving part of each semiconductor apparatus 2 fastened to the FPC tape 1 by the adhesive FT 3. Consequently, each semiconductor apparatus 2 is held fastened in this state to the FPC tape 1 only by the adhesive FT 3. In this example also, the supply and discharge of the FPC tape 1 and thus of the semiconductor apparatus 2, were both done in reel form.

In this example, ACF was used as the adhesive FT 3 and the operating conditions of the hot press adhesion device 14 were a temperature of 120°C, a pressure of 10 kg/cm², and a time of 3 seconds. Also, the pressing pressure exerted by the external cut device 15 was 4 kg/cm².

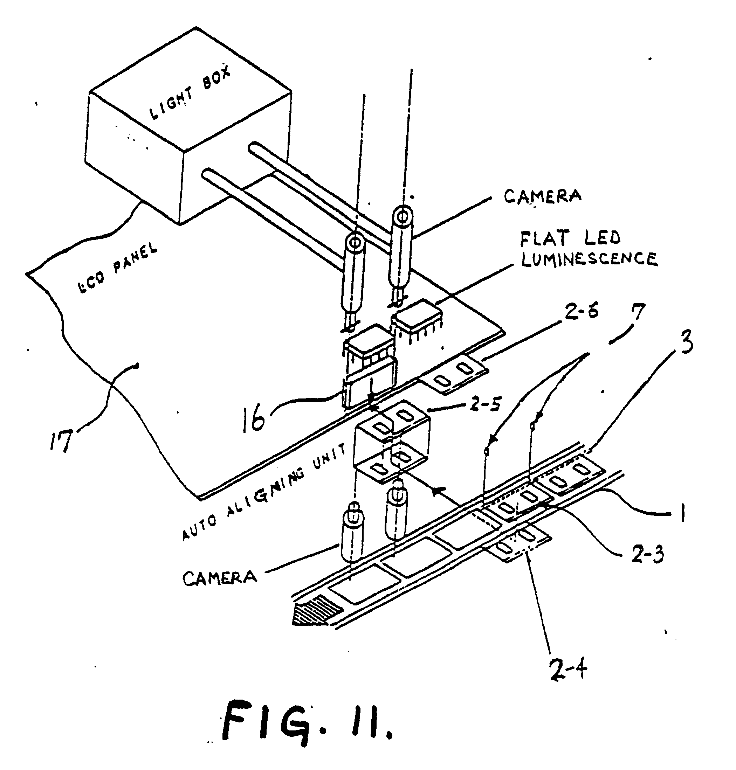

Figure 11 illustrates a method in which the adhesive FT3 is cut by the time that the semiconductor apparatus is connected to the terminal part of a liquid crystal display element 17, for example.

In Figure 11, a plurality of semiconductor apparatuses 2-3, each of which has one part held fastened to FPC tape 1 by adhesive FT 3, after being transported to a prescribed position by the movement of FPC tape 1, has the adhesive FT 3 cut by cutters 7, and is completely separated from the FPC tape 1 for the first time. Semiconductor apparatus 2-4, now constituted by a separated single solid-state element, is transported to the vicinity of the terminal part of liquid crystal display element 17 by a transport means (not shown). Then it is positioned by a positioning means 2-5, that is, by optical recognition of the terminal part of the semiconductor apparatus 2-4 and the terminal part of the liquid crystal display element 17. Next, preliminary press adhesion is effected by means of a press adhesion head 16, and the semiconductor apparatus 2-6 is attached to the terminal part of the liquid crystal display element 17.

After this, when the OLB terminal part of the semiconductor 2-6 is adhered under pressure, the OLB is completed. In this example also, the supply and discharge of the FPC tape 1, and thus of the semiconductor apparatuses 2, to the apparatus shown in Figure 11 were both done in reel form.

Further, the operating conditions of the press adhesion head 16 were room temperature, a pressure of 3 kg/cm², and a time of 1 second.

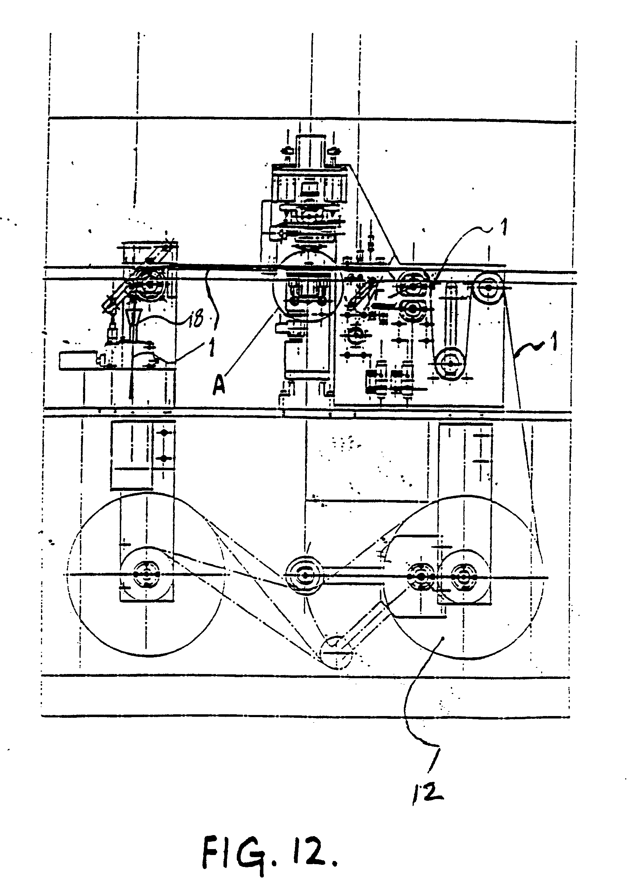

Figure 12 is a front view of an apparatus for carrying out the method illustrated in Figure 11. The FPC tape 1, after the completion of the method illustrated in Figure 10, is shown as having been wound on a reel 12. When the apparatus shown in Figure 12 is actuated, each semiconductor apparatus 2 which is fastened to the FPC tape 1 by adhesive FT 3 has the latter cut at the region A so that it is separated from the FPC tape 1, and is mounted on the terminal part of the liquid crystal display element. The FPC tape 1 which has thus been separated from the semiconductor apparatuses 2 is cut at an FPC tape cutter 18 and is removed.

As indicated above, it is possible to transport and continually process the semiconductor apparatuses 2 in the taped state in one pass, from the ILB process to the OLB process, and it is further possible to realize a single pass mounting line by connecting the apparatus of each process, complete from ILB to OLB.

As described above, it is thus possible to transport semiconductor apparatus very simply from inner lead bonding to outer lead bonding in a taped state so as to effect automation and thus produce inexpensive products.

## Claims

1. A tape assembly comprising a flexible printed circuit (FPC) tape (1) which carries a plurality of semiconductor apparatuses (2) characterised in that each semiconductor apparatus (2) is fastened to the said FPC tape (1) at limited regions (2b,2c) only.

2. A tape assembly as claimed in claim 1 characterised in that each semiconductor apparatus (2) is fastened to the FPC tape (1) only by means of at least one adhesive flexible tape member (3) which is secured to the said FPC tape (1).

3. A tape assembly as claimed in claim 1 characterised in that each semiconductor apparatus (2) is fastened to the FPC tape (1) only by means of thin connector members (6).

4. A tape assembly as claimed in any preceding claim characterised in that the FPC tape (1) is provided with holes (5) on at least one side of each semiconductor apparatus (2), each semiconductor apparatus (2) having been completely cut from the FPC tape (1) along at least one cut line (4) incorporating a respective hole or holes (5), each semiconductor apparatus (2) being fastened to the FPC tape (1) only by fastening means (3,6) which extend across the respective hole or holes (5).

5. A tape assembly as claimed in claim 4 characterised in that each semiconductor azpparatus (2) has at least one pair of holes (5) disposed on opposite sides thereof.

6. A tape assembly as claimed in any preceding claim characterised in that each semiconductor apparatus (2) is constituted by a single solid state unit.

7. A method of effecting outer lead bonding (OLB) of a plurality of semiconductor apparatuses (2) mounted on a flexible printed circuit (FPC) tape (1) characterised in that each semiconductor apparatus (2) is fastened to the said FPC tape (1) at limited regions (2b,2c) only at or immediately prior to the time when OLB is effected.

8. A method as claimed in claim 7 characterised in that each semiconductor apparatus (2) is fastened to the said FPC tape (1) by fastening means (3,6) which are severed immediately prior to the time when OLB is effected.

9. A method as claimed in claim 8 in which the fastening means (3,6) is severed by melting it.

10. A method as claimed in any of claims 7-9 characterised in that, prior to the said OLB, each semiconductor apparatus (2) has inner lead bonding (ILB) carried out thereon at a time when the semiconductor apparatus (2) is securely fastened to the FPC tape (1) and prior to the time when it is fastened thereto only at the said limited regions (2b,2c).

11. An apparatus for making a tape assembly as claimed in claim 1, characterised by first securing means (8) for securing a plurality of semiconductor apparatuses (2) to a flexible printed circuit (FPC) tape 1; second securing means (13,14) for securing each semiconductor apparatus (2) to the FPC tape (1) by means of adhesive flexible tape (3); and cutting means (15) for cutting each semiconductor apparatus (2) away from the FPC tape 1 while leaving it fastened thereto at limited regions (2b,2c) only by the adhesive flexible tape (3).

12. An apparatus as claimed in claim 11 characterised by further cutting means (7) for completely separating each semiconductor apparatus (2) from the FPC tape (1) by severing the adhesive flexible tape (3) which fastened it thereto.

13. An apparatus as claimed in claim 12 characterised by positioning means (2-5) for positioning a semiconductor apparatus (2), which has been completely separated from the FPC tape (1), with respect to a terminal part of a substrate (17) so that they mutually face one another, and electrical connection means (16) for electrically conencting together terminal parts of the semiconductor apparatus (2) and of the substrate (17).

14. Tape carrier, within a tape carrier wherein semiconductor apparatuses (2) are formed continuously on FPC tape (1), characterized in that the said semiconductor apparatuses (2) are separately formed as single-solid state units with parts held fastened to the said FPC tape (1).

15. Tape carrier as claimed in claim 14 characterized in that the parts of the said semiconductor apparatus (2) are held fastened to the said FPC tape (1) by attaching a flexible adhesive tape (3) continuously on the said FPC tape (1).

16. Tape carrier mounting method characterized in that outer lead bonding is done continuously with the semiconductor apparatus (2) on the tape carrier being separately formed as a single solid-state unit so that a part is held fastened on the FPC tape (1).

17. Tape carrier mounting apparatus characterized in that it furnishes at least: (a) means (13,14) of attaching flexible adhesive tape (3) onto the tape carrier (1); (b) means (15) of cutting external shapes of individual semiconductor apparatuses (2) away from the said flexible adhesive tape (3); (c) means of transporting the tape carrier (1) with the flexible adhesive tape (3) attached and with a part of the said semiconductor apparatus (2) held fastened on the FPC tape (1); (d) means (7) of cutting the said flexible adhesive tape (3) in order to separate the said semiconductor apparatuses (2) individually from the !0 said FPC tape (1);, (e) means (2-5) of arranging the terminal parts of the said semiconductor apparatuses (2) and the terminal parts of the substrates so they mutually face one another; and (f) means (16) of electrically connecting the terminal parts of the said semiconductor apparatuses and the terminal parts of the said substrate (17).

FIG. 1.

FIG. 2.

FIG. 3.

FIG. 4.

FIG. 5.

(a)

(b)

(c)

(d)

FIG. 6.

FIG. 7.

(a)                    (b)

# FIG. 8.

FIG. 9.

SUPPLY

13   14

3

1

2

15

DISCHARGE

FIG. 10.

LIGHT BOX

LCD PANEL

CAMERA

FLAT LED LUMINESCENCE

2-6

7

3

2-5

16

AUTO ALIGNING UNIT

17

1

2-3

CAMERA

2-4

# FIG. 11.

FIG. 12.

FIG. 13.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP - A1 - 0 059 092 (ANGELUCCI) * Abstract; fig. 1-4 * | 1,7, 14,16, 17 | H 05 K 13/00 |
| A | EP - A2/A3 - 0 324 244 (IBM) * Abstract; fig. 3-7 * | 1,7, 14,16, 17 | |
| A | WO - A1 - 88/06 348 (LSI-LOGIC) * Abstract; fig. 2-4; claims 1-7 * | 1,7, 14,16, 17 | |
| A | US - A - 4 681 654 (CLEMENTI) * Abstract; fig. 2-5; claims 1-18 * | 1,7, 14,16, 17 | |
| A | US - A - 4 413 308 (BROWN) * Abstract; fig. 1-3 * | 1,7, 14,16 17 | TECHNICAL FIELDS SEARCHED (Int. Cl.5) |
| A | GB - A - 2 164 794 (OY LOHJA) * Abstract; fig. 1-12 * | 1,7, 14,16 17 | H 05 K 13/00 |
| A | GB - A - 2 137 805 (STANLEY) * Abstract; fig. 1-32; claims 1-5 * | 1,7, 14,16 17 | |

The present search report has been drawn up for all claims

| Place of search | Date of completion of the search | Examiner |
|---|---|---|
| VIENNA | 04-12-1990 | VAKIL |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)